# EUROPEAN PATENT APPLICATION

(11) **EP 0 820 093 A1**
(43) Date of publication of application: **21.01.1998**
(21) Application number: 97305183.2
(22) Date of filing: 14.07.1997
(51) Int. Cl.: H01L 21/311, H01L 21/027

(54) **Etching organic antireflective coating from a substrate**

(30) Priority: 15.07.1996 US 683609
(71) Applicant: Applied Materials, Inc., Santa Clara, CA 95054 (US)
(72) Inventor: Zhao, Ganming, Cupertino, California 95014 (US); Ko, Terry, California 94088 (US)
(74) Representative: Allard, Susan Joyce

(57) **Abstract**

A process for etching an organic antireflective coating from a silicon-containing substrate is provided. The substrate is placed into a process chamber and a process gas comprising O and a compound selected from the group consisting of compounds containing H and Br, compounds containing H and I, and mixtures thereof is introduced into the chamber. The compound is preferably HBr. A plasma of the process gas is generated in the process chamber to etch the coating. The process provides substantially anisotropic etching of the coating with excellent critical dimension control, high selectivity of the coating with respect to the substrate, and a high etch rate of the coating.

## Description

The present invention relates generally to a process for etching organic coatings from substrates in semiconductor processing, and particularly to a process for etching organic antireflective coatings from silicon-containing substrates.

Reactive ion etching processes are used to fabricate devices having submicron sized features, such as semiconductor integrated circuit chips. These processes are used to selectively etch a substrate having portions protected by an etch resistant material such as a photoresist pattern or an oxide hardmask. The resist-protected portions form features on the substrate which become part of the integrated circuit being processed. Etching comprises introducing a selected process gas into an etching chamber and producing a plasma from the process gas. The plasma selectively etches the substrate and creates volatile etch byproduct compounds which are removed from the etching chamber.

The process gas is typically a mixture of gases such as, for example, Cl₂, CCl₄ and/or O₂, with or without an inert carrier gas such as He or Ar. A chloroflurocarbon gas is also commonly used in the process gas.

There are a number of problems associated with these process gases. One problem is that chloroflurocarbon gases can be environmentally undesirable, and processes using these gases are subject to environmental regulations.

Another problem is that these gases can chemically react with the resist on the substrate, and cause relatively thick residues or deposits to form on the chamber walls, the sidewalls of the etched features and on the resist material. These residues or deposits can flake off and form particles that contaminate the wafers. Such particles may not be detected until the wafer is fully processed, which can result in the loss of the entire wafer at significant expense.

Another problem with using these process gases is that they can etch features having "reentrant" profiles. "Reentrant" profiles refer to the shape of the sidewalls of the etched features being inwardly sloped. Reentrant profiles are caused by isotropic etching or undercutting, which occurs when etching proceeds not only vertically through the unmasked portions (as desired), but also horizontally below the masked layer. It is preferable that the etched features have substantially vertical sidewalls with angles close to 90 degrees, and that the etched features have substantially the same width as the mask. These desired characteristics result when the process gas anisotropically etches the substrate when etching proceeds substantially vertically through the uncoated portions of the substrate.

As device size continues to shrink below the sub-half micron barrier, the use of organic anti-reflective coatings (ARC) is often required. Such coatings are used in photolithographic processes to reduce reflective notching, standing waves and back scattered light, to maximize photoresist exposure latitude and to optimize photoresist sidewall profiles. Consequently, circuit chip quality is enhanced and wafer rework and loss is reduced.

An antireflective coating can be applied as a top antireflective coating (TAR), or alternatively as a resist-film interface, commonly known as a bottom antireflective coating (BARC). TAR coatings are usually removed during the developing process, while BARC coatings most often require dry etching removal.

Processes for the dry etching of organic antireflective films usually are accomplished in a plasma etch system. ARC etching process gases vary considerably in composition and can include, for example CHF₃/CF₄/Ar-O₂, CF₄/He-O_{2,} O₂/N_{2,} and O₂. In critical gate etch applications, however, in-situ etching of BARC layers over polysilicon or polycide layers using fluorine-containing etchants can leave residual fluorine in the etch chamber which can reduce selectivities to thin gate oxides.

During etching processes, it is desirable to obtain high etch rates and a high etching selectivity. The selectivity is the ratio of the etch rate of the organic bottom antireflective coating to the etch rate of the directly underlying substrate material. A high selectivity is desirable to avoid excessive etching of the substrate. The process gas CF₄/He-O₂ has a low selectivity to polysilicon of about 1.5 to 1 and the process gas CHF₃/CF₄/Ar-O₂ has a low selectivity of about 3 to 1. O₂/N₂ has a higher selectivity of about 50 to 1, but causes excessive losses to critical dimensions of the mask-defined features.

Accordingly, there is a need for a process for etching an organic antireflective coating from a substrate that achieves substantially anisotropic etching of the coating; provides high critical dimension control; has high selectivity; provides a high etch rate, and reduces deposits on the etching chamber walls.

The present invention is directed to a process that satisfies the above needs. The process achieves substantially anisotropic etching of the organic antireflective coating, high etch rates, high selectivity, reduced chamber residue deposition, and high critical dimension control.

The process of the present invention comprises etching an organic coating such as an organic antireflective coating from a substrate. Typically, the coating has a photoresist pattern thereon. The process comprises the steps of:
(a) placing a substrate into an etch zone in a chamber;
(b) introducing into the chamber a process gas containing O and at least one passivating compound selected from the group consisting of (i) compounds containing H and Br and (ii) compounds containing H and I; and
(c) generating a plasma of the process gas in the chamber to etch the coating from the substrate not covered by the photoresist pattern.

### Preferably, the passivating compound is HBr.

The substrate is typically a silicon-containing underlayer on a silicon substrate, but may be a silicon substrate without additional layers. The silicon-containing material typically comprises a layer of polysilicon, a silicide, or a dielectric material.

The passivating compound is preferably introduced into the chamber in an amount effective to (i) substantially prevent etching of the substrate; (ii) produce substantially anisotropic etching of the coating; and (iii) allow the O₂ to etch at a rate greater than about 2000Å/min, preferably greater than about 3000Å/min. During etching, a passivating layer is formed on the sidewalls feature etched into the organic coating. The passivating layer substantially prevents side etching so as to produce substantially anisotropic etching of the organic coating. The sidewalls of the features preferably form angles of at least about 85° relative to the substrate. The angles are more preferably about 85° to 90° relative to the substrate.

The process gas further provides a high organic layer to underlayer selectivity, preferably a ratio of at least about 40:1.

These and other features, aspects and advantages of the present invention will become better understood from the following drawings, description and appended claims, where:
Fig. 1a is a schematic view in vertical cross-section of a substrate having thereon an organic antireflective coating, and the coating having thereon a photoresist pattern;
Fig. 1b is a schematic view in vertical cross-section of the substrate, organic antireflective coating and photoresist pattern of Fig. 1a after etching; and
Fig. 2 is a schematic view in vertical cross-section of an apparatus suitable for practicing the process of the present invention.

Referring to Fig. la, a process according to the present invention is performed in an etching chamber on a substrate 10 comprising a base 12 and an underlying layer 14 which is to be patterned. The base 12 is typically comprised of silicon and the underlying layer 14 can be comprised of doped or undoped polysilicon, a silicide, silicon or a dielectric material such as SiO₂, Si₃N₄, SiₓN_{y}, SiON, SiₓO_{y}N_{z}, or the like.

An organic antireflective coating (BARC) 16 is formed on the underlying layer 14. The organic coating 16 is applied to reduce reflective notching, standing waves and back scattered light, maximize photoresist exposure latitude and optimize photoresist sidewall profiles during the photolithographic process. Exemplary organic antireflective coatings are commercially available under the trademark 'ARC' from Brewer Science, Inc. of Rolla, Missouri. Other organic antireflective coating compositions can also be used. The organic coating 16 typically has a thickness of about 500Å to about 2500Å, most usually about 500Å to about 800Å.

A photoresist pattern 18 is formed on the antireflective organic coating 16 during the photolithographic process. The photoresist pattern 18 is substantially resistant to etching so that the portions of the substrate 10 covered by the photoresist pattern 18 are substantially not etched during the etching of the substrate 10.

The photoresist pattern 18 can comprise upstanding features 30 typically having a minimum width, W, of less than about 0.5µ and a height, H, of less than about 1µ. The features 30 form a profile angle, α, which is typically from about 85° to about 90° relative to the upper surface plane of the antireflective organic coating 16.

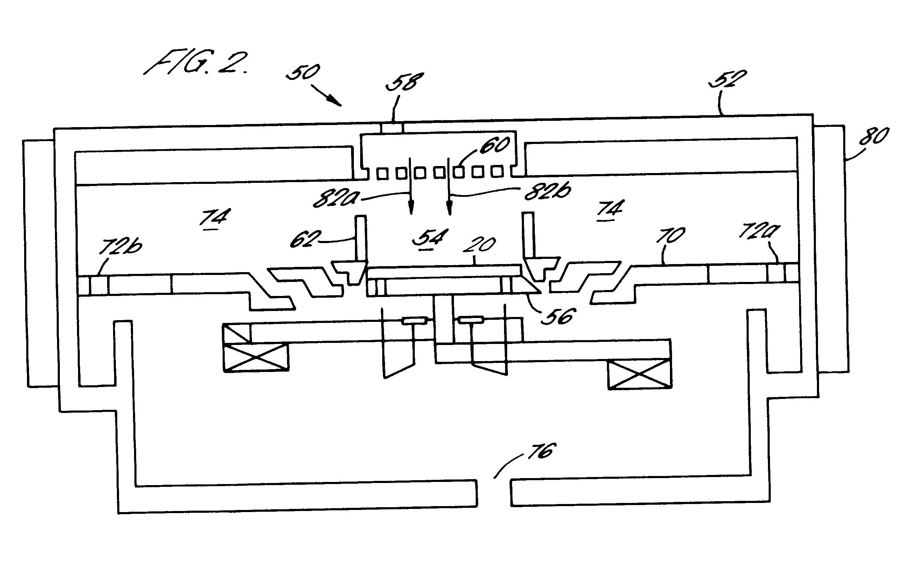

Referring to Fig. 2, a reaction apparatus 50 suitable for practicing the present invention comprises an etching chamber 52 having an etch zone 54. Process gas is introduced into the etching chamber 52 through the gas inlet 58. The process gas then passes through a "showerhead" diffuser plate 60 which distributes the process gas in the etching zone 54. A surrounding focus ring 62 substantially maintains the generated plasma in the etching zone 54.

A barrier or pumping plate 20 defines a plurality of exhaust holes 72a, 72b therethrough and separates the etching chamber 52 into two zones; namely, the etching zone 54 and a non-etching zone 74. The exhaust holes 72a, 72b are in fluid communication with a vacuum pump (not shown) via an exhaust port 76 for exhausting spent process gas and volatile etch byproducts from the etching chamber 52.

The reaction apparatus 50 can be magnetically enhanced. A magnetic coil 80 can be provided around the etching chamber 52 to magnetically enhance the plasma formed from the process gas in the etching zone 54.

In operation, a substrate 10 such as shown in Fig. la is placed on the cathode 56 and a process gas is introduced through the gas inlet 58 into the etching chamber 52. A plasma is generated from the process gas to selectively etch the antireflective organic coating 16.

In accordance with the invention, the process gas comprises 0 and at least one passivating compound selected from the group consisting of compounds containing H and Br, compounds containing H and I-, and mixtures thereof. The preferred compound is HBr. Other suitable compounds include CH₃Br, CH_{z}Br₂, BBr_{2,} CHBr_{3,} Br₂ and the like. Other hydrocarbons containing Br or I can also be used.

Various diluent gases, such as He, other inert gases and CO₂, can also be added to the process gas.

A plasma of the process gas is generated in the etch zone 54. The flow of the plasma is represented by the arrows 82a and 82b.

The composition of the process gas is varied by adjusting the molar ratio of O-containing gas to the passivating compound. A typical molar ratio of HBr to the O in the O-containing gas is about 1:2. The molar ratio of HBr to O in the O-containing gas can be from about 1:20 to about 5:2. Other molar ratios may be used for different process gas compositions. A typical flow rate of the process gas for a reactor as described herein is about 20 sccm.

The process gas preferably comprises an effective amount of the passivating compound to produce sidewall passivation on the newly exposed etched coating sidewall surface, so as to achieve substantially anisotropic etching of the organic antireflective coating.

The plasma is generated from the process gas to etch the antireflective organic coating 16. The power used to generate the plasma is generally from about 100 watts to about 1000 watts, and is typically about 200 watts for a silicon wafer size of 200 mm. A power above about 200 watts can provide sufficient passivation of the antireflective organic coating 16 during etching.

While the invention has been described above with reference to an etch chamber as illustrated in Fig. 2, other reactor types and plasma sources can be utilized to practice the invention. For example, the plasma can optionally be enhanced by a method such as electron cyclotron resonance, magnetic enhancement, and/or inductively coupled power sources. Preferably, a magnetically enhanced ion reactor is used. The magnetic field in the reaction apparatus 50 induced by the magnetic coil 80 must be sufficiently strong to increase the density of the ions formed in the plasma, but below a level that causes charge-up damage. The magnetic field on the surface of the substrate 10 is preferably from about 10 gauss to about 80 gauss, and is more preferably about 40 gauss.

For the type and size of the process chamber described herein, the pressure in the etching chamber 52 is preferably maintained at from about 1 mTorr to about 200 mTorr, and more preferably at from about 15 mTorr to about 20 mTorr. Lower pressures provide more uniform etching, but lower etch rates.

The cathode 56 is maintained at a suitable temperature to prevent volatilization of the passivating deposit that forms during etching. The cathode temperature is preferably from about -15°C to about 60°C, and more preferably from about 0°C to about 20°C.

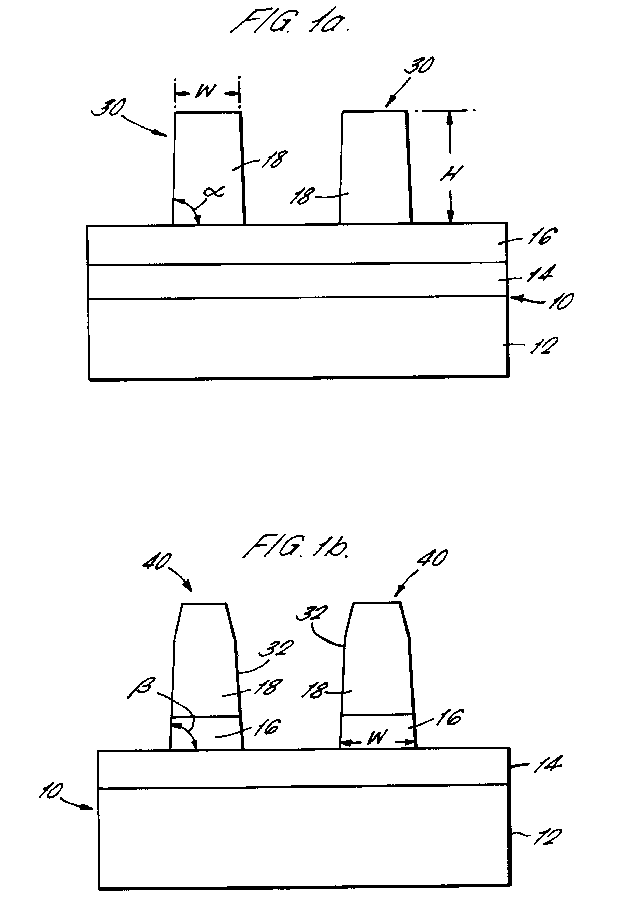

Fig. 1b illustrates the substrate 10 comprising base 12 and underlying layer 14, the antireflective organic coating 16 and the photoresist pattern 18 after etching in accordance with the process of the present invention. As shown, the protected portions of the substrate 10 and antireflective organic coating 16 form features 40. The features 40 comprise sidewalls 32 having a trench profile angle β relative to the substrate 10. This profile angle is preferably at least about 85°, and more preferably from about 85° to about 90°.

The process according to the present invention preferably minimizes the loss of critical dimensions of the features 40 to enhance subsequent etching performance of the substrate 10. The most important critical dimension is the width of the features, W, which ideally should be identical to the width of the photoresist.

The process according to the invention achieves an etch rate of the antireflective organic coating 16 preferably greater than about 2000Å/min, and more preferably greater than about 3000Å/min.

The process gas preferably produces a selectivity of the antireflective organic coating 16 to undoped polysilicon of about 140:1, a selectivity of the antireflective organic coating 16 to SiO₂ of about 40:1, and a selectivity of the organic antireflective coating 16 to the photoresist pattern of at least about 2.

### EXAMPLE

The following example demonstrates the efficacy of the present invention. The example was conducted using a magnetically enhanced reactive ion reactor and, in particular, a "Precision 5000" system available from Applied Materials Inc., Santa Clara, California, having an 8 in. MxP poly chamber.

The wafer tested was a silicon wafer having a diameter of 200 mm (8 in.), coated with an organic antireflective coating of a thickness of about 1550Å. A photoresist pattern was formed on the organic antireflective coating. The photoresist pattern thickness (or feature height) was about 1µ, and the feature width was nominally about 0.45µ. No baking of the wafers was performed.

Referring to Fig. la, a photoresist profile angle, a, of about 85° to 87° was observed using scanning electron microscopy (SEM).

The wafer etching process included a main etch step and a 60% overetch step. Endpoint detection was used for termination of the main etch at a wavelength of 483.5 nm. The process conditions used are set forth in the following TABLE I.

**TABLE I**

| **PROCESS CONDITIONS** | | |
|---|---|---|
| | **Main Etch** | **Overetch** |
| Time (sec) | 35.2 | 21.1 |
| Pressure (mTorr) | 15 | 15 |
| Power (Watts) | 200 | 200 |
| Magnetic field (Gauss) | 40 | 40 |
| O₂ (sccm) | 10 | 10 |
| HBr (sccm) | 10 | 10 |
| Cathode Temperature (°C) | 10 | 10 |

**TABLE II**

| **RESULTS** | | |
|---|---|---|
| | **Center** | **Edge** |
| Critical Dimension | 0.433 | 0.442 |
| Profile angle | 86 | 87 |
| Shoulder Loss (Å) | 1667 | 1500 |
| Photoresist (Å) | 8583/8283 | 8317 |

An etch rate of the organic antireflective coating of about 2300 Å/min was observed. In addition, etching of wafers having polysilicon or SiO₂ layers indicated a selectivity of the organic antireflective coating to polysilicon of about 140:1, and a selectivity of the organic antireflective coating to SiO₂ of about 39:1.

The results of the example demonstrate that a process according to the invention provides a high degree of anisotropic etching, substantially no undercutting or notching, a high selectivity of the organic antireflective coating to polysilicon and SiO₂, and low critical dimension loss.

The present invention has been described in considerable detail with reference to certain preferred embodiments, thereof, however, other embodiments are possible. Therefore, the spirit and scope of the appended claims should not be limited to the description of the preferred embodiments contained herein.

## Claims

1. A process for etching an organic layer on an underlayer, the process comprising the steps of:
(a) introducing into an etching zone a process gas comprising O and at least one passivating compound selected from the group consisting of (i) compounds containing both H and Br, and (ii) compounds containing both H and I;
(b) generating a plasma from the introduced gas; and
(c) contacting the organic layer with the plasma.

2. A process for etching an organic antireflective coating from a substrate, the process comprising the steps of:
(a) placing into a chamber a substrate having a coating thereon comprising an organic antireflective material, the coating having thereabove a photoresist pattern;
(b) introducing into the chamber a process gas comprising 0 and at least one passivating compound selected from the group consisting of (i) compounds containing both H and Br and (ii) compounds containing both H and I; and
(c) generating a plasma of the process gas in the chamber to etch the coating from the substrate not covered by the photoresist pattern.

3. The process of claim 1 or 2, wherein the passivating compound is selected from the group consisting of HBr, HI, hydrocarbons containing Br, and hydrocarbons containing I.

4. The process of claim 1 or 2, wherein the passivating compound is HBr.

5. The process of claim 2, wherein the substrate comprises a silicon layer having thereon a silicon-containing layer.

6. The process of claim 4, wherein the silicon-containing layer comprises doped or undoped polysilicon or a silicide.

7. The process of claim 5, wherein the silicon-containing layer comprises a dielectric material selected from the group consisting of SiO₂, SiₓN_{y} and SiₓO_{y}N_{z}, where x, y and z are integers.

8. The process of claim 1 or 2, wherein the process gas comprises a sufficient amount of the passivating compound to substantially passivate the newly exposed organic layer.

9. The process of claim 1 or 2, wherein the process gas comprises a sufficient amount of the passivating compound to produce substantially anisotropic etching of the coating.

10. The process of claim 2, wherein the substrate comprises features having sidewalls, and the process gas comprises a sufficient amount of the passivating compound that a passivating layer is formed on the sidewalls during etching, the passivating layer substantially preventing side etching so as to produce substantially anisotropic etching of the coating.

11. The process of claim 1, wherein the underlayer is on a substrate, the substrate having features having sidewalls, and the process gas comprises a sufficient amount of the passivating compound that the sidewalls have angles of at least about 85° relative to the substrate after etching.

12. The process of claim 1 or 2, wherein the coating has a thickness of from about 500Å to about 2500Å.

13. The process of claim 1 or 2, wherein the process gas comprises a molar ratio of passivating compound to O of about 1:20 to about 5:2.

14. The process of claim 4, wherein the process gas comprises a molar ratio of HBr to O of about 1:2.

15. The process of claim 1 or 2, wherein the step of introducing a process gas comprises introducing sufficient O to produce an etch rate of the coating greater than about 2000Å/min.

16. The process of claim 1 or 2,- wherein the step of introducing a process gas comprises introducing an effective amount of the process gas to produce an etch rate of the coating greater than about 3000Å/min.

17. The process of claim 1, wherein the molar ratio of passivating compound to O is sufficiently high that the organic layer to underlayer selectivity ratio is at least 40:1.

18. The process of claim 1 wherein the process gas includes a diluent.

19. A process for quickly and selectively etching an organic layer on a silicon-containing layer comprising the steps of:
(a) placing in an etching zone a substrate comprising a silicon-containing underlayer, with a thin organic layer on at least a portion of the underlayer;
(b) introducing into the etching zone a process gas containing O and at least one passivating gas selected from the group consisting of (i) compounds containing hydrogen and bromine and (ii) compounds containing hydrogen and iodine;
(c) generating a plasma from the process gas such that the plasma contacts and etches the organic layer, wherein the process gas contains sufficient oxygen to etch the organic layer at a rate of at least 2000Å/min and the molar ratio of passivating gas to O is sufficiently high that the organic layer to underlayer selectivity ratio is at least 40:1.

20. The process of claim 19 wherein the molar ratio of passivating gas to O is at least 1:20.

21. The process of claim 19 wherein the passivating gas is HBr.

22. The process of claim 19 wherein the organic compound is an anti-reflection coating

23. A process for etching an organic antireflective coating from a substrate, comprising the steps of:
(a) placing into a chamber a silicon-containing substrate having a coating thereon comprising an organic antireflective material, the coating having thereon a photoresist pattern;
(b) introducing into the chamber a process gas comprising O and HBr; and
(c) generating a plasma of the process gas in the chamber to etch the coating not covered by the photoresist pattern.

24. The process of claim 23, wherein the process gas comprises an effective amount of HBr to produce substantially anisotropic etching of the coating.

25. The process of claim 23, wherein the substrate has etched features having sidewalls, and a passivating layer is formed on the sidewalls during etching, the passivating layer substantially preventing side etching so as to produce substantially anisotropic etching.

26. The process of claim 23, wherein the substrate has features comprising sidewalls, and the process gas comprises an effective amount of HBr such that the sidewalls form angles of at least about 85° relative to the substrate.

27. A process for etching an organic antireflective coating from a substrate, comprising the steps of:
(a) placing into a chamber a silicon-containing substrate having a coating thereon comprising an organic antireflective material, the coating having thereon a photoresist pattern;
(b) introducing into the chamber a process gas comprising 0 and HBr; and
(c) generating a plasma of the process gas in the chamber to etch the organic antireflective material from the substrate not covered by the photoresist pattern,
wherein an effective amount of the process gas is introduced into the chamber to (i) substantially prevent etching of the substrate, (ii) produce substantially anisotropic etching of the coating, and (iii) produce an etch rate of the coating greater than about 2000Å/min.

28. A process for etching an organic layer on an underlayer, the process comprising the steps of:
(a) introducing into an etching zone a process gas comprising O and Br₂;
(b) generating a plasma from the introduced gas; and
(c) contacting the organic layer with the plasma.
